# EUROPEAN PATENT SPECIFICATION

(11) **EP 3 091 628 B1**
(45) Date of publication and mention of the grant of the patent: **29.01.2025**
(21) Application number: 16168193.7
(22) Date of filing: 03.05.2016
(51) Int. Cl.: H02H 7/04, G01R 19/25

(54) **INTEGRATED TRANSFORMER HEALTH MONITORING ARCHITECTURE**
INTEGRIERTE TRANSFORMATORGESUNDHEITSÜBERWACHUNGSARCHITEKTUR
ARCHITECTURE DE SURVEILLANCE DE LA SANTÉ DE TRANSFORMATEUR INTÉGRÉ

(30) Priority: 04.05.2015 US 201514703533
(43) Date of publication of application: 09.11.2016
(73) Proprietor: General Electric Technology GmbH, 5400 Baden (CH)
(72) Inventor: PAMULAPARTHY, Balakrishna, 500081 Hyderabad (IN); MUTHUKRISHNAN, Vijayasarathi, Markham, Ontario L6C 0M1 (CA); VINAYAGAM, Balamourougan, Markham, Ontario L6C 0M1 (CA)
(74) Representative: Openshaw & Co.

(56) References cited:
- CN-A- 102 663 535
- CN-A- 102 981 084
- US-A1- 2009 187 344

## Description

### TECHNICAL FIELD

The disclosure relates to transformers, and more particularly relates to an integrated transformer health monitoring architecture and associated processes.

### BACKGROUND

When monitoring data of a power transformer, one or more devices may be utilized for collection of data. These devices may include devices of one or more device types. However, devices of different device types may collect data at different rates. The use of multiple devices of various device types and data collection rates can increase the time and cost associated with utilizing the collected data.

US 2009/0187344 describes a system, analyzing power grid data including a data collection module comprising a plurality of database adapters configured to retrieve non-operational utility data, a data storage module in communication with said data collection module and comprising a database for storing the non-operational utility data, and an analysis and reporting module configured to process the non-operational data and to provide a plurality of reports and a plurality of alarms. The analysis and reporting module may comprise an object library comprising a plurality of objects, wherein each object is configured to perform a specific analysis of utility data, an analysis rules module linking one or more objects of the object library and defining an analysis to be performed. An analysis engine is configured to execute the analysis rules module, and a report generator is configured to produce a report based on an output of the analysis rule module.

### BRIEF SUMMARY OF THE DISCLOSURE

Some or all of the above problems may be addressed by certain embodiments of the disclosure. Certain embodiments may include an integrated transformer health monitoring architecture and associated processes. Other embodiments can include systems and methods for integrating a plurality of devices into a common system for monitoring the health of a power transformer.

The present invention resides in a method, a computer program and a system as defined in the appended claims. Other embodiments, systems, methods, apparatus, aspects, and features of the disclosure will become apparent from the following detailed description, the accompanying drawings, and the appended claims.

### BRIEF DESCRIPTION OF THE FIGURES

The detailed description is set forth with reference to the accompanying drawings, which are not necessarily drawn to scale. The use of the same reference numbers in different figures indicates similar or identical items.
FIG. 1 depicts an example system environment for an integrated transformer health monitoring architecture, according to one embodiment of the disclosure.
FIG. 2 is an example process flow diagram illustrating details of an example method for collecting data in response to determining an event has occurred to a transformer (e.g., during abnormal operating conditions), according to one embodiment of the disclosure.
FIG. 3 is an example process flow diagram illustrating details of an example method for collecting data during normal operating conditions, determining a time-stamp offset between data received from a protection relay device and data received from a monitoring and diagnostics (M&D) device, and time synchronizing data and/or devices, according to one embodiment of the disclosure.
FIG. 4 is a flow diagram illustrating details of an example method for correlating protection data and health monitoring data of a transformer, according to one embodiment of the disclosure.
FIG. 5 is a block diagram of an example computing environment for an integrated transformer health monitoring architecture, according to one embodiment of the disclosure.

### DETAILED DESCRIPTION

Illustrative embodiments will now be described more fully hereinafter with reference to the accompanying drawings, in which some, but not all embodiments of the disclosure may be shown. The disclosure may be embodied in many different forms and should not be construed as limited to the embodiments set forth herein; rather, these embodiments are provided so that this disclosure will satisfy applicable legal requirements. As noted above, like numbers refer to like elements throughout.

Certain embodiments of the disclosure are directed to, among other things, integration of one or more monitoring and diagnostics (M&D) devices into a common system. As used herein, a M&D device can refer to any type of protection relay device, dissolve gas analysis (DGA) device, input/output (IO) device, sensor measuring device, control device, health and/or condition monitoring device, computing device, analysis device, intelligent electronic device, merging unit, and/or the like. One or more M&D devices can be integrated into a common system such that various types of data can be collected, stored, and/or shared between various devices in the system.

For example, a system embodiment of the disclosure may include a protection relay device and one or more M&D devices, each being configured to collect real time data of a transformer of a power system and/or grid. In this manner, a system can be enabled to consistently monitor the health (e.g., status) of the transformer using different types of data.

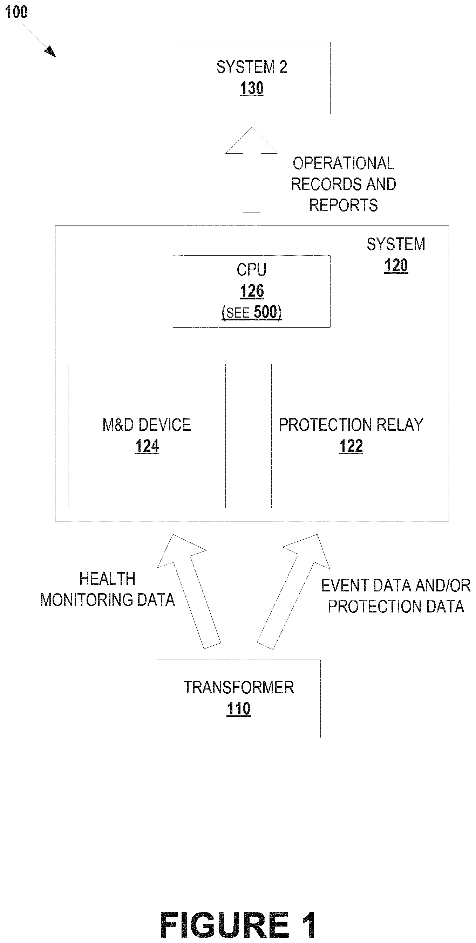

Referring now the figures, FIG. 1 illustrates an example system environment 100 for an integrated transformer health monitoring architecture, according to an embodiment of the disclosure. A transformer 110 (or another device such as a generator, a motor, a turbine, a compressor, and/or the like) can be operatively and/or communicatively connected to a system 120 of the disclosure. In some embodiments, the system 120 can be on site with the transformer 110 and may be incorporated with transformer housing. In other embodiments, the system 120 may be located offsite from the transformer 110. The system 120 may further be operatively and/or communicatively coupled with a second system 130 associated with a user (e.g., a power grid manager, a database manager, a power plant administrator, electrical, service, and/or maintenance engineer, asset manager, and/or the like) such as an offsite database, a computing device, a transformer control panel, and/or the like.

The system 120 can include one or more devices configured to retrieve data from the transformer 110 and/or process data received from the transformer 110. As seen in FIG.1, the system 120 can include a protection relay 122, one or more M&D devices 124, and a computing device (CPU) 126 or processor. In some embodiments, the system 120, the protection relay 122, the one or more M&D devices 124, the CPU 126, and/or another processor may be used interchangeably such that each device of the system 120 (or a device outside of the system within the system environment 100) is capable of performing and/or executing any operation or function disclosed herein.

During operation of the transformer 110, the system 120 can be configured to receive various pieces of data about the transformer 110. This data may be retrieved by the system 120 in various manners and/or with multiple pieces of equipment (e.g., protection relays, M&D devices such as DGA devices, bushing monitoring devices, partial discharge monitoring devices, tap changer monitoring devices, and/or the like). For example, the system 120 may receive, retrieve, and/or sample event data (e.g., data indicative of an occurrence of an event, such as a transformer internal fault, a transformer external fault, a transformer through fault, a transformer disturbance, and/or the like) and/or protection data (e.g., a voltage, a frequency, a current, power, an energy, a harmonic, a power factor, an overload, and/or the like) of the transformer 110 using the protection relay 122. In at least one embodiment, the system 120 may receive, retrieve, and/or sample health monitoring data (e.g., a transformer gas content of oil, thermal data, a condition of an insulation and/or other material, a condition of degradation, an electrical fault signature, mechanical damage indicators, machinery operating and/or historical data, computed models data, auxiliary equipment health information, and/or the like) of the transformer 110 using the one or more M&D devices 124. Typically, data can be received from one or more sensors, input devices, and/or the like of each of the protection relay 122 and the one or more M&D devices 124 at predetermined intervals and/or continuously (e.g., in real or near-real time). Different M&D devices 124 may sample (e.g., retrieve and/or receive) data at different rates. For example, a DGA device may retrieve data associated with oil fumes more slowly than a bushing and a partial discharge device retrieves monitoring data. The protection relay 122, the one or more M&D devices 124, and/or the CPU 126 may each determine a rate (e.g., a speed, an interval length, and/or the like) at which each device operates and therefore account for a delay, a lag, and/or an offset in processing rates during operation (e.g., retrieval, processing, and/or the like of various data types). In some embodiments, the protection relay 122 and/or the one or more M&D devices 124 may generate rate information (e.g., information pertaining to a respective rate of operation and/or sampling of each device such as an operation start time, an operation stop time, an operation cycle length, and/or the like). Upon generation, rate information may be transmitted from the protection relay 122 and/or the one or more M&D devices 124 to the CPU 126 for utilization by the CPU 126 in determining a time offset between two or more operating devices based on a comparison of rate information associated with the two or more operating devices, a calculation of a difference between respective time-stamps of the two or more operating devices, and/or the like. Rate information may be formatted in a variety of formats including a time-stamp in standard and/or military time, a bit stream, a string of alphanumeric characters, an encoded string of alphanumeric characters, wherein each letter corresponds to a number according to a predetermined code and/or mapping of alphanumeric characters to numbers, a text file, and/or the like. Rate information received by the CPU 126 may be formatted by the CPU 126 from a first format to a second common format so that rate information received from various devices, of different format types, and/or of different data types may be efficiently processed by the CPU 126. Once data is received, the system 120 may analyze, process, and/or transmit the received data using the CPU 126.

In some embodiments, the system 120 may first utilize the protection relay 122 to monitor event data and/or protection data of the transformer 110. As stated above, event data and/or protection data may include analog data, digital data, electrical data, voltages, frequencies, currents, characteristics, attributes, parameters, and/or the like of the transformer 110. The protection relay 122 can sample and/or collect event data and/or protection data of the transformer 110 at predetermined intervals or continuously (e.g., in real time). Upon sampling, the retrieved protection data can be assigned a time-stamp by the protection relay 122 that corresponds to a moment in time at which the sampling of the event data and/or protection data occurred. After time-stamping the event data and/or protection data, the protection relay 122 can transmit sampled event data and/or protection data of the transformer 110 to the CPU 126 of the system 120 for analysis.

Upon receipt of the event data and/or protection data, the CPU 126 can store the time-stamped event data and/or protection data in one or more memory locations. The one or more memory locations may be native to the system 120 or may be an offsite server, a cloud server, and/or the like. The CPU 126 may also convert a format of the time-stamped event data and/or protection data into a standardized format that is compatible with other data types.

The CPU 126 can analyze the event data and/or protection data to determine if and when an event occurs with respect to the transformer 110. For example, the CPU 126 may analyze the event data and/or protection data to determine that an event has occurred to the transformer (e.g., determine that a fault or disturbance has occurred, that a spike in power consumption and/or output has occurred, and/or the like). The CPU 126 may analyze the event data and/or protection data to identify a maximum or minimum parameter value (e.g., a voltage) of the transformer 110 that exceeds a predetermined allowable threshold based on a comparison of a measured and/or received value with a threshold value. In this way, the CPU 126 recognizes or otherwise detects an event, such as an abnormality in the event data and/or protection data, which may correlate to a hindrance of operation of the transformer 110. An event may also include one or more of a variety of circumstances with respect to the transformer 110, including, but not limited to, a power failure, a mechanical failure, a manual and/or automatic trip, an electrical failure, an operational fault, a through fault, a power leak, a triggered alarm, a parameter that meets and/or exceeds a predetermined threshold, and/or the like.

The CPU 126 may further generate a confidence score of the likelihood that an identified abnormality in event data and/or protection data is correlated to an operational failure of the transformer 110 based at least in part on one or more measured values of event data and/or protection data. The confidence score typically embodies a numerical value (e.g., 5/100, 66/100, 3/5, 62%, and/or the like) and/or alphanumeric character (A-, C+, and/or the like) that corresponds to a determined likelihood that an identified abnormality in event data and/or protection data is indicative of a transformer failure. In some embodiments, the confidence score is determined based on an evaluation of event data and/or protection data against one or more criteria, such as threshold values for different characteristics of the event data and/or protection data. For example, if a first characteristic of received protection data, such as a spike in voltage associated with the transformer 110, is determined to be greater than or equal to a threshold value of voltage criterion (and/or meets and/or exceeds the threshold value of voltage for a predetermined threshold amount of time), then the CPU 126 may determine a relatively high confidence score to indicate that the spike of voltage (e.g., the spike in protection data) is indicative of a failure. Various events above a predetermined threshold score may be flagged and/or transmitted in an alert message to a user and/or operator of the transformer 110. Further, based at least in part on determining that an event has occurred, the system 120 (e.g., the protection relay 122 and/or the CPU 126) can transmit a command to the one or more M&D devices 124 to initiate sampling of health monitoring data from the transformer 110 in order to analyze a cumulative effect of an event on a transformer health condition.

The one or more M&D devices 124 can be used by the system 120 to retrieve and/or collect data (e.g., health monitoring data, electrical data, mechanical degradation data, and/or signature data) pertaining to mechanical or electrical issues of the transformer 110. For example the one or more M&D devices 124 may be configured to retrieve and/or collect (e.g., sample) data through analyses of gas particles of oil in the transformer 110. Example analyses of gas particles of oil can include, but are not limited to, photoacoustic spectroscopy and gas chromatography. Different M&D devices 124 may be utilized for retrieving different types of health monitoring data (e.g., based on particle size, oil type, and/or the like). Upon sampling, the one or more M&D devices 124 may assign a time-stamp to the retrieved health monitoring data. Typically, the time-stamp corresponds to an instance in time at which the sampling of the health monitoring data occurred. After time-stamping the health monitoring data, the one or more M&D devices 124 can transmit sampled health monitoring data of the transformer 110 to the CPU 126 of the system 120 for processing and/or analysis.

Upon receipt of the health monitoring data, the CPU 126 can store the time-stamped health monitoring data in one or more memory and/or data storage locations. Typically, the CPU 126 can store the time-stamped health monitoring data in the memory location of the time-stamped event data and/or protection data and/or can correlate event data and/or protection data with health monitoring data that has the same time-stamp based at least in part on memory location. The CPU 126 may further convert a format of the time-stamped health monitoring data into a standardized format that is compatible with other data types. For example, the CPU 126 may convert time-stamped health monitoring data that is formatted in standard time to a military time format. Additionally, the CPU 126 may store all received data (e.g., event data, protection data, and/or health monitoring data) in a common data storage file, report, and/or record.

Because sampling health monitoring data of the transformer 110 using the one or more M&D devices 124 may need relatively more computer processing and more time (e.g., more computing power and analysis to retrieve and/or collect health monitoring data of the transformer 110) than sampling event data and/or protection data of the transformer 110 using the protection relay 122, the CPU 126 can be configured to determine a time-stamp offset to be added to a time-stamp of at least one of the time-stamped event data and/or protection data and the time-stamped health monitoring data. For example, the CPU 126 may determine a difference in time between a first time-stamp of a first device (e.g., a protection relay 122) and a second device (e.g., an M&D device 124). In some embodiments, the time-stamp may be a numerical value of a portion of seconds, minutes, hours, days, weeks, months, years, and/or the like. In this way, the system 120 can ensure that time-stamps of all data (e.g., event data, protection data, and/or health monitoring data) sampled and/or received at the same time are accurately synchronized with each other.

Furthermore, because sampling health monitoring data of the transformer 110 using the one or more M&D devices 124 can be a time-consuming process, a commanded sample of health monitoring data may have to be scheduled in advance by the system 120. For example, the system 120 may determine whether the one or more M&D devices 124 are currently sampling health monitoring data of the transformer 110 (e.g., determine a state of the one or more M&D devices 124) by continuously monitoring the state(s) of the one or more M&D devices 124. If it is determined that the one or more M&D devices 124 are indeed currently sampling health monitoring data of the transformer 110 (e.g., determined that the state(s) of the one or more M&D devices 124 is not in standby), then the system 120 may schedule the one or more M&D devices 124 at a next available time-stamp. If it is determined that the one or more M&D devices 124 are not currently sampling health monitoring data of the transformer 110 (e.g., determined that the state(s) of the one or more M&D devices 124 is in standby), then the system 120 may prompt the one or more M&D devices 124 to begin sampling immediately, or at a predetermined time.

The CPU 126 can be further configured to recall and/or retrieve stored data (e.g., event data, protection data, and/or health monitoring data) for one or more analyses. For example, in response to determining that an event has occurred with respect to the transformer 110, the CPU 126 may recall available historic data or a sample of data that was time-stamped immediately prior to the time-stamp of the determined occurred event (e.g., pre-data) and/or a sample of data that was time-stamped immediately or multiple data samples (e.g., 'N' samples) collected after the time-stamp of the determined occurred event (e.g., post-data). In some embodiments, recalling pre-data and post-data may include determining a time-stamp of event data, protection data, and/or health monitoring data stored in memory and identifying event data, protection data, and/or health monitoring data stored in memory as event pre-data, event post-data, protection pre-data, protection post-data, health monitoring pre-data, and/or health monitoring post-data based at least in part on their respective time-stamps.

The CPU 126 may analyze pre-data and post-data for a variety of purposes. For example, pre-data and post-data may be analyzed to determine a cause of the event that occurred with respect to the transformer 110 or understand an amount of stress experienced by the transformer 110 due to an occurrence of an event. In this way, pre-data and post-data can be utilized to understand the status of the transformer 110 immediately prior to and immediately after the occurrence of the event, as pre-data and post-data may be indicative of particular extreme parameters or other factors that contributed to occurrence of the event (e.g., a failure). The CPU 126 may also determine, based at least in part on an analysis of data (e.g., event data, protection data, health monitoring data, pre-data, and/or post-data) an event type.

In some embodiments, an analysis of data by the CPU 126 may include comparing recently received event data, protection data, and/or health monitoring data to historical data (e.g., historical event data, historical protection data, and/or historical health monitoring data) stored in memory. In this manner, the CPU 126 can be configured to compare recently received data to historical data that is indicative of an occurrence of a particular historical event with respect to the transformer 110. Based at least in part on determining a match between the recently received data and historical data that is indicative of an occurrence of a historical event to the same transformer 110 or another transformer, the CPU 126 may determine that an event of the same event type as the type of historical event has recently occurred to the transformer 110. A similar analysis may also be implemented by the CPU 126 to determine an event type and/or event cause of a recently-occurred event.

Based at least in part on an analysis of data, the CPU 126 can be configured to determine and/or predict a cause of an event determined to have occurred with respect to the transformer 110. In some embodiments, the CPU 126 can be further configured to predict a future event, a cause of a future event, and/or a type of a future event, such as a maintenance failure, of the transformer 110. In response to predicting a future event of the transformer 110, the CPU 126 may generate and/or schedule a maintenance request to repair the transformer 110, log it as an event in memory, and/or raise an alarm, a caution, a warning, and/or the like prior to an occurrence of the predicted future event. The system 120 may transmit a maintenance or frequent monitoring request to the second system 130, which, in certain embodiments, may be associated with a maintenance server and/or designated authorized person or persons.

In some embodiments, analyzing data can include determining one or more parameters of the transformer 110 (e.g., an aspect of an electrical component, a mechanical component, an auxiliary component, and/or the like) no longer comply with one or more regulatory standards and/or fault codes. The CPU 126 may compare received and/or historic data of the transformer 110 to data associated with a transformer that does not comply with one or more regulatory standards and/or fault codes. For example, incoming and/or recently-received data (e.g., event data, protection data, and/or health monitoring data) may be compared with data stored in a database associated with a known failure and/or particular failure type (e.g., an event known to not comply with one or more regulatory standards and/or fault codes). In this manner, the CPU 126 can be enabled to determine at least a partial match between the recently-received data and historical data associated with a known failure and/or particular failure type. Based at least in part on determining at least a partial match between the received and/or historic data of the transformer 110 and data associated with a transformer that does not comply with one or more regulatory standards and/or fault codes, the CPU 126 may determine that the transformer 110 needs maintenance and/or replacement.

Additionally, the CPU 126 can be configured to generate one or more reports based at least in part on an analysis of data. For example, the CPU 126 may generate an energization record that highlights identified power and/or electrical issues of the transformer 110 based at least in part on parameters associated with received protection data such as a power failure, extreme fluctuations in current, harmonics, inrush current level, and/or the like. Further, health monitoring data collected during an energization process (e.g., a power-up, a shut-down, and/or the like) can be correlated with event data, protection data, and/or other types of data to understand a stress level on the transformer 110 during an energization cycle.

So, When a transformer energization status is detected by the protection relay 122, for example, a start data record (e.g., energization record) may be triggered, and the protection relay 122 may begin to sample and record a variety of parameters at a rate depending on a source of parameter (e.g., whether the parameter is being sampled either from the protection relay 122 or a DGA monitor device, and/or the like). In some embodiments, the parameter(s) may include: a maximum 2^{nd} harmonic inrush root mean square (RMS) current magnitude in one or more phases (e.g., phases A, B, and/or C); a maximum percent level of a 2^{nd} harmonic with respect to one or more fundamental in in one or more phases (e.g., phases A, B, and/or C); a maximum 5^{th} harmonic inrush root mean square (RMS) current magnitude in one or more phases (e.g., phases A, B, and/or C); a maximum percent level of a 5^{th} harmonic with respect to one or more fundamental in in one or more phases (e.g., phases A, B, and/or C); harmonic content(s)s in an inrush current; an inrush-current-to-steady-state-magnetizing-current decay time; an RMS voltage drop during energization; a transient overvoltage magnitude and/or its duration; power quality data such as voltage sags, voltage swells, a total harmonic distortion (THD), and/or a harmonic distortion factor (HDF); 2^{nd} to 25^{th} harmonic levels; true RMS values of one or more phases (e.g., phase A, B, and/or C), as well as their respective currents (e.g., currents Ia, Ib, and/or Ic); an average of true RMS values of the three-phase currents (e.g., current Iavg); a true RMS value of a ground current (e.g., Ig); a current unbalance (%); true RMS values of each phase (e.g., A-N, B-N, and/or C-N) and/or respective voltages (e.g., Van, Vbn, and Vcn); a three-phase real power; a three-phase reactive power; a three-phase power factor; a frequency; a transformer status; a winding hot-spot temperature; a top-oil temperature; an aging factor; a loss-of-life; a DGA gas parts-per-million (ppm) and/or ppm-per-day values for one or more devices; ;gas ratio values; a DGA model status; measured input/output (I/O) channel data, bushing data; on-load tap changer (OLTC) DGA data; partial discharge data; electrical signature analysis data; thermal imaging data; and any other transformer condition monitoring data, in general.

In another example, the CPU 126 may generate a learned data record that includes actual received data (e.g., event data, protection data, and/or health monitoring data) of the transformer 110 and a plot of the actual data. The CPU 126 may, based at least in part on the analysis and/or plot of actual data, correlate data of various data types and/or identify and/or predict one or more trends of transformer behavior. For example, the CPU 126 may determine a pattern of failures based on the data and/or environmental conditions such as determining a fault is recurring over a particular period of time (e.g., determining that a particular transformer element fails due to a peak load in summer months, correlating an overload condition of the transformer 110 with a gas particle-per-million (ppm) generation rate, monitoring winding insulation deterioration, commonly analyzing a hot-spot temperature, an aging factor, a loss-of-life, and/or gas ppm data, and/or the like), and/or the like.

Typically, the protection relay 122 measures and records individual data records from actual transformer operation. A latest individual data record "set" may be viewed using a learned data feature on the protection relay 122. This data, when input cumulatively to a learned data recorder (e.g., when analyzed and/or stored by the CPU 126), may be used to evaluate changes and/or trends over time. In some embodiments, content(s) of the learned data may include: a learned and/or last maximum energization RMS inrush phase magnitude and/or current magnitude, a learned percent of a 2nd and/or 5th harmonic level, a learned inrush-current-to-steady-state-magnetizing-current decay time; a learned RMS voltage drop during energization; a learned transient overvoltage magnitude and/or duration; learned power quality data such as voltage sags, voltage swells, a total harmonic distortion (THD), and/or a harmonic distortion factor (HDF); learned 2nd to 25th harmonic levels; a learned HDF for each winding; a learned maximum WHST; a learned maximum top-oil temperature; a last breaker arcing current; a learned average load; a learned average real power; a learned average reactive power; a learned maximum transformer overload; a last aging factor; a last loss-of-life; a learned maximum THD; a learned percent current unbalance; a learned maximum total dissolved combustible gas (TDCG); a learned maximum gas ppm value; learned maximum gas RoC values; a learned moisture level; a learned DGA model output; learned measured I/O channel data; learned bushing data; learned OLTC DGA data; learned partial discharge data; learned electrical signature analysis data; learned Thermal imaging data; and any other transformer condition monitoring data, in general.

In another embodiment, the CPU 126 may generate an integrated fault report that can include an analysis of stress levels incurred by the transformer 110 prior to, during, and after occurrence of an event. A fault report may also include a determined change in parameter levels of the transformer 110 between pre-data and post-data. The CPU 126 may further determine a lifespan of the transformer 110 and/or a transformer element (e.g., a part, a system, and/or the like of the transformer 110) based at least in part on an analysis of data and/or calculated data points such as a number of events (e.g., faults), their event types, a frequency of events, and/or the like incurred by the transformer 110. For example the CPU 126 may determine that a particular fault type (e.g., an event) has occurred, which caused electrical and/or mechanical stress on transformer 110, based on transient waveforms, fault data, pre & post protection data, pre & post M&D data, nameplate data, computed data, transformer models & fault codes computed with pre & post fault data, and/or the like. The CPU 126 may identify, store, and/or learn a fault type (e.g., event type) of the determined fault and/or event and use the information for predicting if a similar fault may occur in the future.

The CPU 126 may also generate a digital fault report (DFR) record using health monitoring data and event data through a DGA analysis. In some embodiments, DFR records may capture associated analog and/or digital signal parameters based on pre-data and/or post-data that surround an occurred event. In this manner, health monitoring data, protection data, and/or event data may be used to help an operator understand an amount of stress the transformer 110 has undergone due to a fault event which caused the transformer 110 to trip and/or malfunction.

Transformer events like faults and outages typically occur very fast and subject the transformer 110 to undergoing severe and/or moderate stress conditions. As a number of fault or trip conditions increases during an operational life of the transformer 110, and based on the progress in transformer asset age, risk associated with transformer failure may gradually increase. Hence, predicting fault conditions early based on the amount of stress experienced by the transformer 110 may require multiple data types to be captured during each transformer event, (e.g., event data, protection data, health monitoring data, and/or the like). By modeling data of each transformer event and type of fault, fault prediction might be possible.

Another type of data to be collected and/or processed by the CPU 126 may include DFR data, which may include pre- and/or post-event gas ppm and/or rate-of-change gas ppm values of all DGA gases, associated DGA fault codes derived from a Duval triangle, a gas ratio, a key gas, and/or any other DGA models computation. DFR data shall also include a measured I/O channel, DGA gas information, bushing, OLTC DGA, partial discharge, signature analysis, thermal imaging and any other transformer condition monitoring data suitable for a fault report. Health monitoring data in line with protection data in a fault report shall help operators to understand amount of stress the transformer 110 and/or its internal or auxiliary components have undergone due to the fault event.

As stated above, a transformer event is defined for this specification as any abnormal condition (e.g., internal fault) or outage (e.g., due to external fault) which caused the transformer 110 to trip condition and/or momentarily shut down. A transformer event may, in some embodiments, be sensed by a transformer energization condition through breakers' statuses. In some embodiments, transformer events may be determined based on faults of various function operations, such as: instantaneous differential protection relay 122 operation; a percent differential in protection relay 122 operation; a phase, neutral, and.or ground state over current; a harmonic derating factor (HDF), a tap changer failure; thermal elements; overload conditions; THD; a restricted ground fault; a negative sequence over current; 2nd and/or 5th harmonic levels; over excitation; over and/or under frequency; manual stop commands; and/or DGA faults.

The CPU 126 may also generate a historical max record. The CPU 126 can be configured to compare each received data value (e.g., received event data, protection data, and/or health monitoring data) to a historical maximum value stored in memory of a similar data and/or parameter type. The CPU 126 can determine which of the two data values is a maximum (or a minimum, an average, and/or the like), and can assign a corresponding maximum tag to the determined maximum. In this manner, the system 120 can keep track of (e.g., stores) extreme values for each parameter of the transformer 110 along with a time-stamp over its lifetime. In some embodiments, parameters include: transformer energization RMS inrush phase current magnitudes; percents of 2nd and/or 5th harmonic levels; an inrush-current-to-steady-state-magnetizing-current decay time; an RMS voltage drop during energization; a transient overvoltage magnitude and/or duration; power quality data such as voltage sags, voltage swells, a total harmonic distortion (THD), and/or a harmonic distortion factor (HDF); 2nd to 25th harmonic levels; an HDF for each winding; a WHST and associated winding; a top-oil temperature; a breaker arcing current; an average load; an average real power; an average reactive power; a transformer overload level; an aging factor; a THD level; a percent current unbalance; a TDCG; DGA gas ppm values; DGA gas ppm and/or rate-of-change values; a percent moisture (RH) level; measured I/O channel data; bushing data; OLTC DGA data; partial discharge data; electrical signature analysis data; thermal imaging data; and any other transformer condition monitoring data, in general.

The CPU 126 may also generate a transformer health report that can summarize an analysis of some or all data of the transformer 110 discussed in various embodiments. The transformer health report may include some or all measured parameters of the transformer 110 at each point in time, recommendations and/or status of maintenance and/or maintenance requests, and/or the like.

A transformer fleet report may also be generated by the CPU 126. The transformer fleet report can include and/or combine data from one or more transformer health reports for multiple transformers in a power system and/or utility grid. The transformer fleet report may also include a determined capacity of a power plant and/or geographic area of a power distribution system, identified events and/or problematic transformers, a ranking, a risk index, and/or the like.

Each of the reports and/or data itself may be transmitted to the second system 130 for review, additional processing, and/or display. In some embodiments, data and/or reports may be presented to a user via a display on a mobile computing and/or communication device associated with the second system 130. In other embodiments, data and/or reports may be generated and transmitted as a document, an email, a message, a tweet, a text, and/or the like. The data and/or reports may also be uploaded to a network-based or cloud-based server so that they are accessible by one or more users. User authentication may be needed for accessing the data and/or reports.

The system 120 can be further configured to utilize the protection relay 122 or another device to control operation of the transformer 110. For example, if the system 120 determines, based at least in part on an analysis of data of the transformer 110, that the transformer 110 has experienced an event that includes a failure of a mechanical component of the transformer 110, then the protection relay 122 may (in response to determining a particular event type), shut off operation or otherwise control operation of the transformer 110.

The system 120 may also be integrated with one or more transformers. In this manner, the system 120 may enable the communication, transmittal, receipt, and/or sharing of data between transformers and/or transformer control systems. In some embodiments, the system 120 can be configured to monitor one or more transformers, analyze data associated with a plurality of transformers, and/or control one or more transformers.

In the manner described above, certain embodiments of the disclosure can enable various types of data to be retrieved and analyzed within a common system, such as 120. By analyzing different types of data that was sampled at the same points in time, the system 120 may more accurately identify events that have occurred to the transformer 110, as well as the cause of these identified events. Therefore, certain embodiments of the system, such as 120, can conserve both time and money with regard to maintaining the health of the transformer 110. At least one technical effect of certain embodiments of the disclosure can include improved predictive failure analysis for transformers.

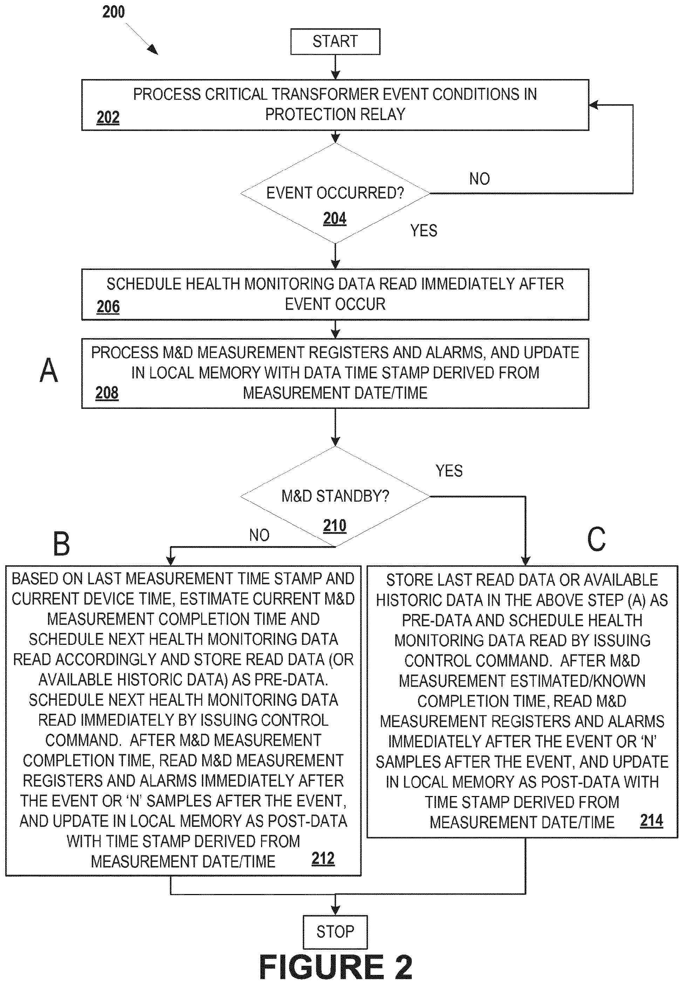

FIG. 2 is an example process flow diagram 200 illustrating details of an example method for collecting data during abnormal operating conditions and in response to determining an event has occurred to a transformer, according to one embodiment of the disclosure. The diagram 200 begins at block 204 with the system 120 (e.g., the CPU 126) determining that an event has occurred to the transformer 110 based on analyzing protection data received from the protection relay 122 at block 202. Once an occurrence of an event has been determined, the system 120, at block 206, initiates and/or commands a scheduling of the one or more M&D devices 124 to sample health monitoring data of the transformer 110 at the a next available sampling time (e.g., immediately). At block 208, the system 120 then ensures that correct time-stamps are assigned to each data value (e.g., parameter, protection data, health monitoring data, and/or the like). The system 120 determines a state of the one or more M&D devices 124 at block 210, and based on the determined state (e.g., idle or not idle, standby or not standby, and/or the like), the system 120 either schedules (e.g., block 212) and/or initiates sampling (e.g., block 214) of health monitoring data of the transformer 110 using the one or more M&D devices 124. The system 120 also computes an amount of time required to complete a sampling of health monitoring data of the transformer 110 using the one or more M&D devices 124. This computed amount of time may be used in determining when to schedule and/or initiate sampling of health monitoring data of the transformer 110 using the one or more M&D devices 124. The one or more M&D devices 124 immediately sample health monitoring data of the transformer 110 if the state(s) of the one or more M&D devices 124 is determined to be idle. If the state(s) of the one or more M&D devices 124 is determined to not be idle (e.g., busy), the system 120 stores a last-read set of health monitoring data in memory with a time-stamp and assigns a label of pre-data to the last-read set of health monitoring data. At a predetermined scheduled time, the one or more M&D devices 124 sample health monitoring data of the transformer 110. The system 120 then stores this sampled health monitoring data in memory with a time-stamp and assigns a label of post-data to the sampled health monitoring data. In this manner, the system 120 is configured to collect health monitoring pre-data and health monitoring post-data.

Additionally, when protection data and/or event data is received from the protection relay to detect an event, one or more reads of data may be immediately scheduled. For example, at block A, health monitoring data received from the one or more M&D devices during routine sampling that occurred at and/or before a time-stamp of a determined occurred event is processed. Registers of the one or more M&D devices may already include stored health monitoring data and/or alarms. Depending on the state of the one or more M&D devices when an event is determined to have occurred, the health monitoring data and/or alarms in the registers of the one or more M&D devices may or may not include health monitoring data that corresponds to (e.g., is time-stamped) the time-stamp of the occurred event. Therefore, the health monitoring data stored in the registers of the one or more M&D devices may not relate to the occurred event.

Accordingly, if the state of the one or more M&D devices is standby, such as at block C (e.g., block 214), the system may store a last read set of health monitoring data stored in the registers of the one or more M&D devices and/or available historical data as pre-data (e.g., health monitoring pre-data), command the one or more M&D devices to read a new set of health monitoring data and/or schedule a next read of a new set of health monitoring data for one or more samples after the event, and store the new set of health monitoring data as post-data (e.g., health monitoring post-data). The system may then associate and/or correlate the pre-data and/or post-data with the event data and/or protection data used to determine an occurrence of an event and/or the event.

Alternatively, if the state of the one or more M&D devices is not standby such as at block B (e.g., block 212), then the system follows the same procedure as outlined above for block C. However, the system may utilize the last read health monitoring data stored in registers of the one or more M&D devices to schedule a next read of a new set of health monitoring data, which is to be read in and stored by the system. In some embodiments, reads of health monitoring data may be scheduled when the transformer is in a particular state (e.g., energized, de-energized, and/or the like).

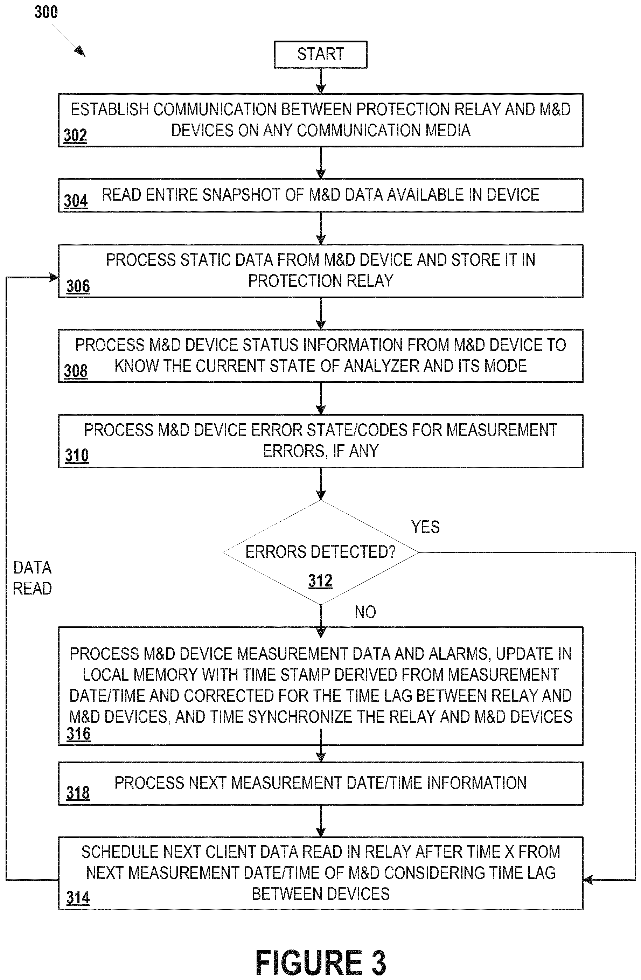

FIG. 3 is an example process flow diagram illustrating details of an example method 300 for collecting data from one or more devices during normal transformer operation and determining a time-stamp offset between data received from a protection relay device and data received from a dissolved gas analysis (DGA) device, according to one embodiment of the disclosure. The diagram begins at block 302 with the system 120 establishing communication between the protection relay 122 and the one or more M&D devices 124. At block 304, the system 120 (e.g., the CPU 126) then reads (e.g., retrieves) health monitoring data from the one or more M&D devices 124 and protection data from the protection relay 122. The system 120 then, at block 306, processes time-stamps of the health monitoring data and the protection data to estimate a current time lag between the assignment of time-stamps to each of protection data and health monitoring data. Typically, time-stamping executed by the one or more M&D devices 124 lags behind time-stamping executed by the protection relay 122. The system 120 then determines, at block 308, a current state of the one or more M&D devices 124 so that the system 120 may measure and/or analyze the one or more M&D devices 124 for any errors at block 310. If, at decision block 312, an error is detected by the system 120, the system 120 follows the YES branch and, at block 314, schedules a read (e.g., retrieval) of protection data of the transformer 110 using the protection relay 122 at a time that corresponds to the next available time that the one or more M&D devices 124 are able to sample (e.g., retrieve and/or read) health monitoring data of the transformer. By scheduling a retrieval of both protection data and health monitoring data at the same time, the system 120 is enabled to calculate a time-stamp offset that should be added to either protection data and/or health monitoring data to thereby ensure that data retrieved (e.g., sampled) at the same time has the same time-stamp. Returning to decision block 312, if no error is detected by the system 120, the NO branch is followed, and the system 120, at block 316, immediately retrieves health monitoring data from the one or more M&D devices 124 and assigns a time-stamp to the retrieved health monitoring data that accounts for any lag in between data retrieved (e.g., sampled) from the protection relay 122 and the one or more M&D devices 124. The system 120 then continues at block 318 by processing a next measurement date and/or time information that may be received from a user and/or based on a previous measurement date and/or time. Using the next measurement date and/or time information, the system 120 may schedule a next client data read at block 314. The next client data read may include reading data from the protection relay 122 and/or the one or more M&D devices 124 at a predetermined date and/or time, wherein the predetermined date and/or time compensates for a determined time lag and/or time offset between devices. After data is read, the system 120 returns to block 306 to process data from the one or more M&D devices 124. Additionally, the system 120 may time synchronize all relays and/or M&D devices 124 based on a global-positioning-system (GPS)-based time reference. The system 120 may also command the protection relay 122 to time synchronize one or more M&D devices 124 at regular intervals.

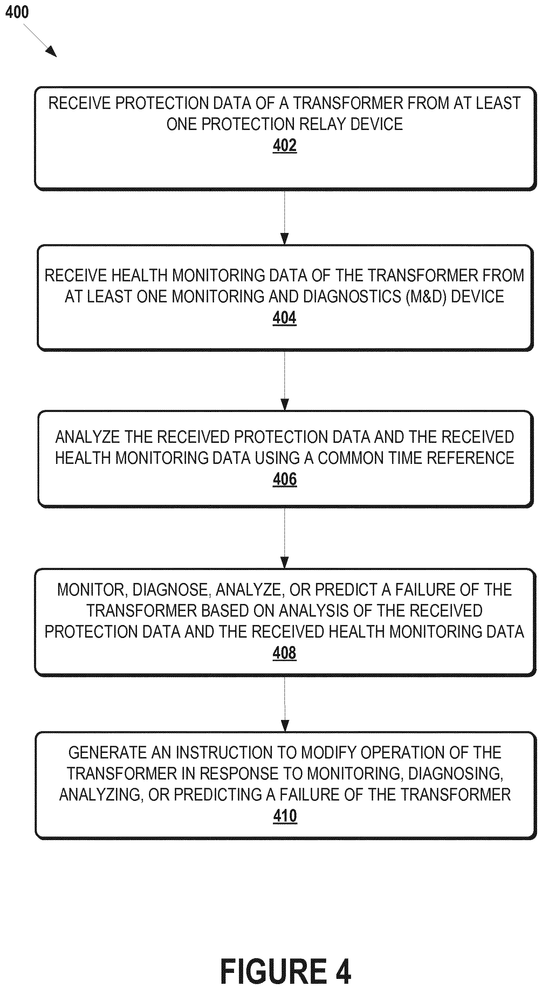

FIG. 4 is a flow diagram illustrating details of an example method 400 for correlating protection data and health monitoring data of a transformer, according to one embodiment of the disclosure. At block 402, the method 400 can include receiving protection data of a transformer from the at least one protection relay device. At block 404, the method 400 can include receiving health monitoring data of the transformer from the at least one monitoring and diagnostics (M&D) device. At block 406, the method 400 can include analyzing the received protection data and the received health monitoring data using a common reference. At block 408, the method 400 can include monitoring, diagnosing, analyzing, or predicting a failure of the transformer based at least in part on analysis of the received protection data and the received health monitoring data. At block 410, the method 400 can include generating an instruction to modify operation of the transformer in response to monitoring, diagnosing, analyzing, or predicting a failure of the transformer.

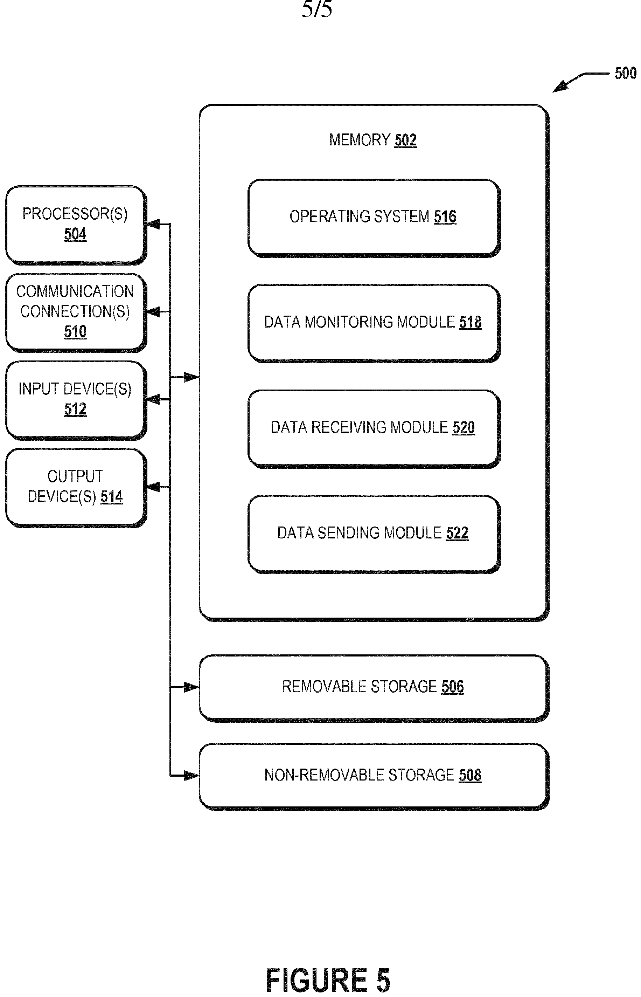

FIG. 5 is a block diagram of an example computing environment 500 for an integrated transformer health monitoring architecture, according to one embodiment of the disclosure. The computing environment 500 can include one or more devices (e.g., protection relays, M&D devices, and/or the like) which can include a processor 504 capable of communicating with a memory 502. The processor 504 may be implemented as appropriate in hardware, software, firmware, or combinations thereof. Software or firmware implementations of the processor 504 may include computer-executable or machine-executable instructions written in any suitable programming language to perform the various functions described.

A memory 502 can store program instructions that are loadable and executable on the processor 504, as well as data generated during the execution of these programs. Depending on the configuration and type of computing environment 500, a memory 502 may be volatile (such as random access memory (RAM)) and/or non-volatile (such as read-only memory (ROM), flash memory, etc.). In some embodiments, the devices may also include additional removable storage 506 and/or non-removable storage 508 including, but not limited to, magnetic storage, optical disks, and/or tape storage. The disk drives and their associated non-transitory computer-readable media may provide non-volatile storage of computer-readable instructions, data structures, program modules, and other data for the devices. In some implementations, the memory 502 may include multiple different types of memory, such as static random access memory (SRAM), dynamic random access memory (DRAM), or ROM.

The memory 502, removable storage 506, and non-removable storage 508 are all examples of non-transitory computer-readable storage media. For example, computer-readable storage media may include volatile and non-volatile, removable and non-removable media implemented in any method or technology for storage of information such as computer-readable instructions, data structures, program modules or other data. Additional types of computer storage media that may be present include, but are not limited to, programmable random access memory (PRAM), SRAM, DRAM, RAM, ROM, electrically erasable programmable read-only memory (EEPROM), flash memory or other memory technology, compact disc read-only memory (CD-ROM), digital versatile discs (DVD) or other optical storage, magnetic cassettes, magnetic tapes, magnetic disk storage or other magnetic storage devices, or any other medium which can be used to store the desired information and which can be accessed by the devices. Combinations of any of the above should also be included within the scope of computer-readable media.

The computing environment 500 may also contain one or more communication connections 510 that allow the devices to communicate with devices or equipment capable of communicating with a computing device. The connections can be established via various data communication channels or ports, such as USB or COM ports to receive connections for cables connecting the devices, e.g., control devices, to various other devices in a system. Devices in the system environment 100 (e.g., system 120, protection relay devices 122, M&D devices 124, the CPU 126, the transformer 110, and/or the second system 130) can include communication drivers such as Ethernet drivers that enable the devices to communicate with other devices in the system environment 100. According to various embodiments, the connections 510 may be established via a wired and/or wireless connection in the system environment 100. The computing environment 500 may also include one or more input devices 512, such as a keyboard, mouse, pen, voice input device, and touch input device. It may also include one or more output devices 514, such as a display, printer, and speakers.

In other embodiments, however, non-transitory computer-readable communication media may include transitory and/or non-transitory computer-readable instructions, program modules, or other data transmitted within a data signal, such as a carrier wave, or other transmission. As used herein, however, non-transitory computer-readable storage media does not include non-transitory computer-readable communication media.

Turning to the contents of the memory 502, the memory 502 can include, but is not limited to, an operating system (OS) 516 and one or more application programs or services for implementing the features and aspects disclosed herein. Such application or services can include a data monitoring module 518, a data receiving module 520, and an data sending module 622. In one embodiment, the modules 518, 520, and 522 can be implemented by software that is provided in configurable control block language and is stored in non-volatile memory.

In one embodiment, the OS 516 can include a QNX^{®} real-time, multitasking operating system. The data monitoring module 518 can monitor multiple devices for data (e.g., protection data, health monitoring data, pre-data, post-data, historical data, event data, protection data, health monitoring data, and/or the like) in the system environment 100. In one embodiment, each of the devices in the system environment 100 can be monitored by a control device executing program code for the data monitoring module 518. Each control device in the system environment 100 can also be configured to monitor data from the same, fewer, or more of the devices in the system environment 100 such that each control device can receive data from each of the devices. In addition to devices, the data monitoring module 518 may also monitor data from other devices, such as control devices or other computing devices (e.g., the second system 130).

Certain embodiments herein relate to communication between devices that may or may not be configured for safety integrity level (SIL). As used herein, SIL can relate to a target level of risk reduction associated with the performance of devices in the system environment 100. In one embodiment, both SIL and non-SIL devices can be monitored by control devices. For example, control devices that may not be configured for SIL can receive data from devices that may be configured for or not configured for SIL.

The data receiving module 520 can receive data from the devices. In one embodiment, a control device executing the data receiving module 520 can receive the data that were being monitored by the data monitoring module 518 at the control device. The data can include various data, text, signals, or other information that may be encoded for proper transmission throughout the system environment 100, e.g., via TCP/IP,UDP/IP, and/or any serial protocol. The data can be received at various predetermined rates, including every 10-, 20-, or 30-milliseconds. Devices can be configured to send data at the predetermined rates such that all data can be sent to the control devices simultaneously. The data can include various types of information. In one example, the information can include monitoring data for an asset. In one aspect of this example, the monitoring data can be received from a sensor associated with the asset, such as a transformer. The data can be received via multicast or unicast according to certain embodiments herein.

The data sending module 522 can send output data from a control device, or other device executing the data sending module 522, to devices. The data sending module 522 can enable control devices to send output data to a subset or only certain ones of the devices in the system environment 100. For example, one control device can send output data to one subset of devices while another control device can send output data, e.g., the same output data, to another subset of devices. In this way, all of the devices can receive output data, albeit from different control devices in the above example. According to one embodiment, the devices can receive output data only from a particular control device, e.g., the control device to which it has been configured to listen. Additionally, the data sending module 522 can send output data to other control devices or computing devices. In one embodiment, the data received from the devices can be sent from a control device, e.g., as output data, to such other control devices or computing devices. In one embodiment, output data can be sent via multicast or unicast and can include, but are not limited to, various data, text, signals, or other information that may be encoded for proper transmission in the system environment 100, e.g., via TCP/IP and/or UDP/IP protocol.

Computer-executable program instructions may be loaded onto a special-purpose computer or other particular machine, a processor, or other programmable data processing apparatus to produce a particular machine, such that execution of the instructions on the computer, processor, or other programmable data processing apparatus causes one or more functions or operations specified in the flow diagrams to be performed. These computer program instructions may also be stored in a computer-readable storage medium (CRSM) that upon execution may direct a computer or other programmable data processing apparatus to function in a particular manner, such that the instructions stored in the computer-readable storage medium produce an article of manufacture including instruction means that implement one or more functions or operations specified in the flow diagrams. The computer program instructions may also be loaded onto a computer or other programmable data processing apparatus to cause a series of operational elements or steps to be performed on the computer or other programmable apparatus to produce a computer-implemented process.

Additional types of CRSM that may be present in any of the devices described herein may include, but are not limited to, programmable random access memory (PRAM), SRAM, DRAM, RAM, ROM, electrically erasable programmable read-only memory (EEPROM), flash memory or other memory technology, compact disc read-only memory (CD-ROM), digital versatile disc (DVD) or other optical storage, magnetic cassettes, magnetic tape, magnetic disk storage or other magnetic storage devices, or any other medium which can be used to store the information and which can be accessed. Combinations of any of the above are also included within the scope of CRSM. Alternatively, computer-readable communication media (CRCM) may include computer-readable instructions, program modules, or other data transmitted within a data signal, such as a carrier wave, or other transmission. However, as used herein, CRSM does not include CRCM.

In some embodiments, a system for correlating protection data and health monitoring data of a transformer is provided. The system includes: at least one protection relay device communicatively coupled to the transformer; at least one M&D device communicatively coupled to the transformer and the at least one protection relay device; and at least one processor communicatively coupled to the at least one protection relay device and the at least one M&D device and configured to: receive protection data of the transformer from the at least one protection relay device; receive health monitoring data of the transformer from the at least one M&D device; analyze the received protection data and the received health monitoring data; predict a failure of the transformer based at least in part on analysis of the received protection data and the received health monitoring data; and generate an instruction to modify operation of the transformer in response to prediction of a failure of the transformer.

In some embodiments, the at least one processor is further configured to: retrieve historical data of the transformer from a database; compare at least a portion of the received protection data and at least a portion of the received health monitoring data to the historical data; determine, based at least in part on comparison of at least a portion of the received protection data and at least a portion of the received health monitoring data to the historical data, at least a partial match between at least a portion of the received protection data and at least a portion of the received health monitoring data and the historical data, wherein at least a portion of the received protection data and at least a portion of the received health monitoring data match a portion of historical data indicative of a previous failure of the transformer; and identify, based on determination of a match between at least a portion of the received protection data and at least a portion of the received health monitoring data and the historical data, a failure of the transformer.

In some embodiments, the at least one processor is further configured to: time-stamp the received protection data upon receipt of the protection data; time-stamp the received health monitoring data upon the receipt of health monitoring data; compare the time-stamp of the received protection data to the time-stamp of the received health monitoring data; determine an estimated current time lag between receiving the protection data and receiving the health monitoring data based on comparing the time-stamp of the received protection data to the time-stamp of the received health monitoring data; and assign an offset of time equal to the estimated current time lag between receiving the protection data and receiving the health monitoring data to the time-stamp of at least one of the received protection data and the health monitoring data so that protection data and health monitoring data sampled at the same point in time are assigned a common time-stamp.

In some embodiments, the at least one processor is further configured to: predict a next required maintenance for the transformer based on analyzing the received protection data and the received health monitoring data; schedule the next required maintenance for the transformer in a calendar; generate a calendar request for maintenance based on the predicted next required maintenance; and transmit the calendar request to a second system.

In some embodiments, the at least one processor is further configured to: determine, based at least in part on analyzing the received protection data and the received health monitoring data, that the transformer no longer complies with at least one set of regulatory standards.

In some embodiments, the processor is further configured to: stop operation of the transformer in response to predicting a failure of the transformer.

In some embodiments, the at least one processor is further configured to: correlate the received protection data and the received health monitoring data.

In some embodiments, the at least one processor is further configured to: calculate a lifespan of at least one component of the transformer based on analyzing the received protection data and the received health monitoring data.

In some embodiments, the at least one processor is further configured to: predict a cause and a type of the predicted failure of the transformer based at least in part on analysis of the received protection data and the received health monitoring data.

In some embodiments, the at least one processor is further configured to: format the received protection data and the received health monitoring data into a common format.

In some embodiments, a method for correlating protection data and dissolved gas analysis (DGA) data of a transformer is provided. The method includes: receiving, by a computing device processor, protection data of the transformer from at least one protection relay device communicatively coupled to the transformer and at least one M&D device communicatively coupled to the transformer and the at least one protection relay device; receiving, by a computing device processor, health monitoring data of the transformer from the at least one M&D device; analyzing, by a computing device processor, the received protection data and the received health monitoring data; predicting, by a computing device processor, a failure of the transformer based at least in part on analysis of the received protection data and the received health monitoring data; and generating, by a computing device processor, an instruction to modify operation of the transformer in response to prediction of a failure of the transformer.

In some embodiments, the method further includes: retrieving, by a computing device processor, historical data of the transformer from a database; comparing, by a computing device processor, at least a portion of the received protection data and at least a portion of the received health monitoring data to the historical data; determining, by a computing device processor and based at least in part on comparison of at least a portion of the received protection data and at least a portion of the received health monitoring data to the historical data, at least a partial match between at least a portion of the received protection data and at least a portion of the received health monitoring data and the historical data, wherein at least a portion of the received protection data and at least a portion of the received health monitoring data match a portion of historical data indicative of a previous failure of the transformer; and identifying, by a computing device processor and based on determination of a match between at least a portion of the received protection data and at least a portion of the received health monitoring data and the historical data, a failure of the transformer.

In some embodiments, the method further includes: time-stamping, by a computing device processor, the received protection data upon receipt of the protection data; time-stamping, by a computing device processor, the received health monitoring data upon the receipt of health monitoring data; comparing, by a computing device processor, the time-stamp of the received protection data to the time-stamp of the received health monitoring data; determining, by a computing device processor, an estimated current time lag between receiving the protection data and receiving the health monitoring data based on comparing the time-stamp of the received protection data to the time-stamp of the received health monitoring data; and assigning, by a computing device processor, an offset of time equal to the estimated current time lag between receiving the protection data and receiving the health monitoring data to the time-stamp of at least one of the received protection data and the health monitoring data so that protection data and health monitoring data sampled at the same point in time are assigned a common time-stamp; and time synchronizing the at least one protection relay device and the at least one M&D device to a common global positioning system (GPS) time source.

In some embodiments, the method further includes: predicting, by a computing device processor, a next required maintenance for the transformer based on analyzing the received protection data and the received health monitoring data; scheduling, by a computing device processor, the next required maintenance for the transformer in a calendar; generating, by a computing device processor, a calendar request for maintenance based on the predicted next required maintenance; and transmitting, by a computing device processor, the calendar request to a second system.

In some embodiments, the method further includes: determining, by a computing device processor and based at least in part on analyzing the received protection data and the received health monitoring data, that the transformer no longer complies with at least one set of regulatory standards.

In some embodiments, the method further includes: stopping, by a computing device processor, operation of the transformer in response to predicting a failure of the transformer.

In some embodiments, the method further includes: correlating, by a computing device processor, the received protection data and the received health monitoring data.

In some embodiments, the method further includes: calculating, by a computing device processor, a lifespan of at least one component of the transformer based on analyzing the received protection data and the received health monitoring data.

In some embodiments, the method further includes: predicting, by a computing device processor, a cause and a type of the predicted failure of the transformer based at least in part on analysis of the received protection data and the received health monitoring data.

In some embodiments, a system for correlating protection data and dissolved gas analysis (DGA) data of a transformer is provided. The system includes: a transformer of a power distribution network; at least one protection relay device communicatively coupled to the transformer; at least one M&D device communicatively coupled to the transformer and the at least one protection relay device; and at least one processor communicatively coupled to the at least one protection relay device and the at least one M&D device and configured to: receive protection data of the transformer from the at least one protection relay device; receive health monitoring data of the transformer from the at least one M&D device; analyze the received protection data and the received health monitoring data; predict a failure of the transformer based at least in part on analysis of the received protection data and the received health monitoring data; and generate an instruction to modify operation of the transformer in response to prediction of a failure of the transformer.

In some embodiments, a system for recording protection data and dissolved gas analysis (DGA) data of a transformer is provided. The system includes: at least one protection relay device communicatively coupled to the transformer; at least one M&D device communicatively coupled to the transformer and the at least one protection relay device; and at least one processor communicatively coupled to the at least one protection relay device and the at least one M&D device and configured to: receive event data from the at least one protection relay device; receive protection data of the transformer from the at least one protection relay device; receive health monitoring data of the transformer from the at least one M&D device; generate a record associated with the transformer, the record based at least in part on the received protection data, the received health monitoring data, and the received event data; and output, based at least in part on the record, a portion of data associated with the record in at least one of a user interface, a report, or an electronic communication.

In some embodiments, the at least one processor is further configured to: sample and time-stamp protection data of the transformer at a predetermined rate using the protection relay device; receive protection data of the transformer from the protection relay device; and determine an event has occurred to the transformer based at least in part on an analysis of the received protection data.

In some embodiments, the at least one processor is further configured to: determine an amount of stress sustained or experienced by the transformer during the event.

In some embodiments, the at least one processor is further configured to: estimate a completion time of generating the record of the transformer based at least in part on analyzing the received protection data and the received health monitoring data; and schedule a time to generate a second record of the transformer based at least in part on a second analysis of received protection data and received health monitoring data.

In some embodiments, the at least one processor is further configured to: identify a maximum value of one or more transformer parameters included in at least one of the received protection data and the received health monitoring data; compare the identified maximum value to a stored maximum value of a parameter of an identical parameter type as the parameter type of the identified maximum value, wherein the stored maximum value is included in at least one of historic protection data and historic health monitoring data of the transformer stored in memory; determine the identified maximum value is greater than the stored maximum value; and update at least one of the historic protection data and the historic health monitoring data by overwriting the stored maximum value with the identified maximum value in at least one of the historic protection data and the historic health monitoring data in memory.

In some embodiments, the at least one processor is further configured to: store at least a portion of the received protection data and the received health monitoring data in memory, wherein at least a portion of the received protection data and the received health monitoring data is accessible to a user via a distributed network of computing devices; generate a report using at least a portion of the received protection data and the received health monitoring data based at least in part on analyzing the received protection data and the received health monitoring data, the report including a status of the transformer, a prediction of an occurrence of an event, and at least one recommendation for maintaining the transformer based at least in part on the prediction of the occurrence of the event; and transmit the report to a second system for presentation to a user.

In some embodiments, the at least one processor is further configured to: schedule the at least one M&D device to sample health monitoring data of the transformer in response to receiving protection data; determine a state of the at least one M&D device is not on standby; and sample health monitoring data of the transformer at a predetermined rate using the at least one M&D device.

In some embodiments, the at least one processor is further configured to: determine a state of operation of the at least one M&D device; schedule a DGA measurement for the at least one M&D device in response to determining that the state of operation of the at least one M&D device is not idle; and initiate a DGA measurement for the at least one M&D device in response to determining that the state of operation of the at least one M&D device is idle.

In some embodiments, the at least one processor is further configured to: retrieve historic data from a memory location, wherein the historic data includes pre-data and post-data, wherein the pre-data includes a time-stamp that precedes a determined event, and wherein the post-data includes a time-stamp that follows the determined event.

In some embodiments, the at least one processor is further configured to: identify one or more trends of behavior of the transformer based at least in part on the received protection data, the received health monitoring data, and the received event data.

In some embodiments, a method for recording protection data and dissolved gas analysis (DGA) data of a transformer is provided. The method includes: receiving, by a computing device processor, event data from the at least one protection relay device communicatively coupled to the transformer and at least one M&D device communicatively coupled to the transformer and the at least one protection relay device; receiving, by a computing device processor, protection data of the transformer from the at least one protection relay device; receiving, by a computing device processor, health monitoring data of the transformer from the at least one M&D device; generating, by a computing device processor, a record associated with the transformer, the record based at least in part on the received protection data, the received health monitoring data, and the received event data; and outputting, by a computing device processor and based at least in part on the record, a portion of data associated with the record in at least one of a user interface, a report, or an electronic communication.

In some embodiments, the method further includes: sampling and time-stamping, by a computing device processor, protection data of the transformer at a predetermined rate using the protection relay device; receiving, by a computing device processor, protection data of the transformer from the protection relay device; and determining, by a computing device processor, an event has occurred to the transformer based at least in part on an analysis of the received protection data.

In some embodiments, the method further includes: determining, by a computing device processor, an amount of stress sustained or experienced by the transformer during the event.

In some embodiments, the method further includes: estimating, by a computing device processor, a completion time of generating the record of the transformer based at least in part on analyzing the received protection data and the received health monitoring data; and scheduling, by a computing device processor, a time to generate a second record of the transformer based at least in part on a second analysis of received protection data and received health monitoring data.

In some embodiments, the method further includes: identifying, by a computing device processor, a maximum value of one or more transformer parameters included in at least one of the received protection data and the received health monitoring data; comparing, by a computing device processor, the identified maximum value to a stored maximum value of a parameter of an identical parameter type as the parameter type of the identified maximum value, wherein the stored maximum value is included in at least one of historic protection data and historic health monitoring data of the transformer stored in memory; determining, by a computing device processor, the identified maximum value is greater than the stored maximum value; and updating, by a computing device processor, at least one of the historic protection data and the historic health monitoring data by overwriting the stored maximum value with the identified maximum value in at least one of the historic protection data and the historic health monitoring data in memory.

In some embodiments, the method further includes: storing, by a computing device processor, at least a portion of the received protection data and the received health monitoring data in memory, wherein at least a portion of the received protection data and the received health monitoring data is accessible to a user via a distributed network of computing devices; generating, by a computing device processor, a report using at least a portion of the received protection data and the received health monitoring data based at least in part on analyzing the received protection data and the received health monitoring data, the report including a status of the transformer, a prediction of an occurrence of an event, and at least one recommendation for maintaining the transformer based at least in part on the prediction of the occurrence of the event; and transmitting, by a computing device processor, the report to a second system for presentation to a user.

In some embodiments, the method further includes: scheduling, by a computing device processor, the at least one M&D device to sample health monitoring data of the transformer in response to receiving protection data; determining, by a computing device processor, a state of the at least one M&D device is not on standby; and sampling, by a computing device processor, health monitoring data of the transformer at a predetermined rate using the at least one M&D device.

In some embodiments, the method further includes: determining, by a computing device processor, a state of operation of the at least one M&D device; scheduling, by a computing device processor, a DGA measurement for the at least one M&D device in response to determining that the state of operation of the at least one M&D device is not idle; and initiating, by a computing device processor, a DGA measurement for the at least one M&D device in response to determining that the state of operation of the at least one M&D device is idle.

In some embodiments, the method further includes: retrieving, by a computing device processor, historic data from a memory location, wherein the historic data includes pre-data and post-data, wherein the pre-data includes a time-stamp that precedes a determined event, and wherein the post-data includes a time-stamp that follows the determined event.

In some embodiments, a system for recording protection data and dissolved gas analysis (DGA) data of a transformer is included. The system includes: a transformer of a power distribution grid; at least one protection relay device communicatively coupled to the transformer; at least one M&D device communicatively coupled to the transformer and the at least one protection relay device; and at least one processor communicatively coupled to the at least one protection relay device and the at least one M&D device and configured to: receive event data from the at least one protection relay device; receive protection data of the transformer from the at least one protection relay device; receive health monitoring data of the transformer from the at least one M&D device; generate a record associated with the transformer, the record based at least in part on the received protection data, the received health monitoring data, and the received event data; and output, based at least in part on the record, a portion of data associated with the record in at least one of a user interface, a report, or an electronic communication.

In some embodiments, the transformer can include at least one of a generator, a motor, a turbine, a static or rotating machine, and an engine.

In some embodiments, receiving health monitoring data comprises determining whether a state of the at least one M&D device is standby; wherein when the state of the at least one M&D device is determined to be standby, begin sampling health monitoring data immediately; and wherein when the state of the at least one M&D device is determined to not be standby, schedule sampling health monitoring data of the transformer for a next available time.

In some embodiments, a processor of the system is configured to receive event data from the at least one protection relay device at a first timestamp; receive protection data of the transformer from the at least one protection relay device at a second timestamp; determine an event has occurred to the transformer based at least in part on the event data and the protection data; receive health monitoring data of the transformer from the at least one M&D device at a third timestamp in response to determining the event has occurred to the transformer; calculate an offset between at least two of the first timestamp, the second timestamp, and the third timestamp; modify at least one of the first timestamp, the second timestamp, and the third timestamp using the offset, thereby resulting in at least one modified timestamp; generating a record of the event using at least a portion of the event data, the protection data, and the health monitoring data, wherein the record comprises at least one modified timestamp; and accessing the record for event data to output to at least one display during operation of the transformer.

In some embodiments, the at least one processor is further configured to: receive protection data of a transformer from the at least one protection relay device; determine an event has occurred to the transformer based at least in part on an analysis of the received protection data; receive health monitoring data of the transformer from the at least one M&D device, wherein receiving health monitoring data comprises: receiving at least one of a last read of health monitoring data or available historical health monitoring data as health monitoring pre-data; and receiving one or more samples of health monitoring data collected after detection of the event or available historical health monitoring data as health monitoring post-data; analyze the received protection data and the received health monitoring data; and generate at least one of a fault report, an energization record, a learned data record, a historical maximum record, a health report, or a fleet report.

In some embodiments, the at least one processor is further configured to: receive event data from the at least one protection relay device; receive protection data of the transformer from the at least one protection relay device; receive health monitoring data of the transformer from the at least one M&D device; generate a record associated with the transformer, the record based at least in part on the received protection data, the received health monitoring data, and the received event data; and output, based at least in part on the record, a portion of data associated with the record in at least one of a user interface, a report, or an electronic communication

While certain embodiments of the disclosure have been described in connection with what is presently considered to be the most practical and various embodiments, it is to be understood that the disclosure is not to be limited to the disclosed embodiments, but on the contrary, is intended to cover various modifications and equivalent arrangements included within the scope of the appended claims. Although specific terms are employed herein, they are used in a generic and descriptive sense only and not for purposes of limitation.

This written description uses examples to disclose certain embodiments of the disclosure and also to enable any person skilled in the art to practice certain embodiments of the disclosure, including, but not limited to, making and using any devices or systems and performing any incorporated methods. The patentable scope of certain embodiments of the disclosure is defined in the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A method comprising:
receiving, by a computing device processor (126), protection data of a transformer (110) from at least one protection relay device (122);
receiving, by the computing device processor (126), health monitoring data of the transformer (110) from at least one monitoring and diagnostics (M&D) device (124);
time-stamping, by the computing device processor (126), the received protection and health monitoring data upon receipt of the protection data and the health monitoring data;
analyzing, by the computing device processor (126), the received protection data and the received health monitoring data using a common time reference;
determining, by the computing device processor (126), the occurrence of an event associated with the transformer (110) based at least in part on analysis of the received protection data and the received health monitoring data;
recalling, by the computing device processor (126), pre-data comprising available historic data or a sample of data that was time-stamped immediately prior to the time-stamp of the determined occurred event and post-data comprising a sample of data that was time-stamped immediately or multiple data samples collected after the time-stamp of the determined occurred event;
generating, by the computing device processor (126), an instruction to modify operation of the transformer (110) in response to determining the occurrence of an event associated with the transformer (110);
analyzing by the computing device processor (126), the pre-data and post-data to determine a cause of the event that occurred with respect to the transformer (110) or to determine an amount of stress experienced by the transformer (110) due to the occurrence of the event; and **characterised by**
comparing, by the computing device processor (126), the time-stamp of the received protection data to the time-stamp of the received health monitoring data;
determining, by the computing device processor (126), an estimated current time lag between receiving the protection data and receiving the health monitoring data based on comparing the time-stamp of the received protection data to the time-stamp of the received health monitoring data; and
assigning, by the computing device processor (126), an offset of time equal to the estimated current time lag between receiving the protection data and receiving the health monitoring data to the time-stamp of at least one of the received protection data and the health monitoring data so that protection data and health monitoring data sampled at the same point in time are assigned a common time-stamp; and
time synchronizing, by the computing device processor (126), the at least one protection relay device (122) and the at least one M&D device (124) to a common global positioning system (GPS) time source.

2. The method of claim 1, further comprising:
retrieving, by the computing device processor (126), historical data of the transformer from a database;
comparing, by the computing device processor (126), at least a portion of the received protection data and at least a portion of the received health monitoring data to the historical data;
determining, by the computing device processor (126) and based at least in part on comparison of at least a portion of the received protection data and at least a portion of the received health monitoring data to the historical data, at least a partial match between at least a portion of the received protection data and at least a portion of the received health monitoring data and the historical data, wherein at least a portion of the received protection data and at least a portion of the received health monitoring data match a portion of historical data indicative of a previous failure of the transformer (110); and
identifying, by the computing device processor (126) and based on determination of a match between at least a portion of the received protection data and at least a portion of the received health monitoring data and the historical data, a failure of the transformer (110).

3. The method of any of claims 1 and 2, further comprising:
predicting, by the computing device processor (126), a next required maintenance for the transformer (110) based on analyzing the received protection data and the received health monitoring data;
scheduling, by the computing device processor (126), the next required maintenance for the transformer (110) in a calendar;
generating, by the computing device processor (126), a calendar request for maintenance based on the predicted next required maintenance; and
transmitting, by the computing device processor (126), the calendar request to a second system (130).

4. The method of any of claims 1 to 3, further comprising:
determining, by the computing device processor (126) and based at least in part on analyzing the received protection data and the received health monitoring data, that the transformer (110) no longer complies with at least one set of regulatory standards.

5. The method of any of claims 1 to 4, further comprising:
predicting a failure of the transformer (110), by the computing device processor (126), based at least in part on analysis of the received protection data and the received health monitoring data; and
stopping, by the computing device processor (126), operation of the transformer in response to predicting a failure of the transformer (110)

6. The method of any of claims 1 to 5, further comprising:
correlating, by the computing device processor (126), the received protection data and the received health monitoring data.

7. The method of any preceding claim, further comprising:
calculating, by the computing device processor (126), a lifespan of at least one component of the transformer (110) based on analyzing the received protection data and the received health monitoring data.

8. The method of any preceding claim, further comprising:
predicting, by the computing device processor (126), a cause and a type of the predicted failure of the transformer (110) based at least in part on analysis of the received protection data and the received health monitoring data.

9. A computer program comprising computer program code means adapted to perform the method of any of claims 1 to 8, when executed by a computer processor.

10. The computer program of claim 9, embodied on a computer-readable medium.

11. A system (100) comprising:
at least one protection relay device (122);
at least one monitoring and diagnostics (M&D) device (124) communicatively coupled to the at least one protection relay device (122); and
at least one processor (126) communicatively coupled to the at least one protection relay device (122) and the at least one M&D device (124) and configured to excute the computer program of claim 10 to perform the method of any of claims 1 to 8.

## Patentansprüche

1. Verfahren, umfassend:
Empfangen von Schutzdaten eines Transformators (110) von zumindest einer Schutzrelaisvorrichtung (122) durch einen Rechenvorrichtungsprozessor (126);
Empfangen von Zustandsüberwachungsdaten des Transformators (110) von zumindest einer Vorrichtung zur Überwachung und Diagnose (M&D) (124) durch den Rechenvorrichtungsprozessor (126);
Versehen der empfangenen Schutz- und Zustandsüberwachungsdaten mit einem Zeitstempel nach Empfang der Schutzdaten und der Zustandsüberwachungsdaten durch den Rechenvorrichtungsprozessor (126);
Analysieren der empfangenen Schutzdaten und der empfangenen Zustandsüberwachungsdaten durch den Rechenvorrichtungsprozessor (126) unter Verwendung einer gemeinsamen Zeitreferenz;
Bestimmen des Auftretens eines Ereignisses, welches mit dem Transformator (110) verknüpft ist, durch den Rechenvorrichtungsprozessor (126), zumindest teilweise basierend auf Analyse der empfangenen Schutzdaten und der empfangenen Zustandsüberwachungsdaten;
Abrufen, durch den Rechenvorrichtungsprozessor (126), von Vordaten, welche verfügbare historische Daten oder eine Datenprobe umfassen, welche unmittelbar vor dem Zeitstempel des bestimmten aufgetretenen Ereignisses mit einem Zeitstempel versehen wurde, und von Nachdaten, welche eine Datenprobe, welche unmittelbar mit einem Zeitstempel versehen wurde, oder mehrere Datenproben umfassen, welche nach dem Zeitstempel des bestimmten aufgetretenen Ereignisses gesammelt wurden;
Erzeugen einer Anweisung zum Ändern des Betriebs des Transformators (110) durch den Rechenvorrichtungsprozessor (126), als Reaktion auf Bestimmen des Auftretens eines mit dem Transformator (110) verknüpften Ereignisses;
Analysieren der Vordaten und Nachdaten durch den Rechenvorrichtungsprozessor (126), um eine Ursache des in Bezug auf den Transformator (110) aufgetretenen Ereignisses zu bestimmen oder um ein Maß an Beanspruchung zu bestimmen, welchem der Transformator (110) aufgrund des Auftretens des Ereignisses ausgesetzt war; und **gekennzeichnet durch** Vergleichen des Zeitstempels der empfangenen Schutzdaten mit dem Zeitstempel der empfangenen Zustandsüberwachungsdaten durch den Rechenvorrichtungsprozessor (126);
Bestimmen einer geschätzten aktuellen Zeitverzögerung zwischen Empfangen der Schutzdaten und Empfangen der Zustandsüberwachungsdaten durch den Rechenvorrichtungsprozessor (126) basierend auf Vergleichen des Zeitstempels der empfangenen Schutzdaten mit dem Zeitstempel der empfangenen Zustandsüberwachungsdaten; und
Zuweisen eines Zeitversatzes, welcher der geschätzten aktuellen Zeitverzögerung zwischen Empfangen der Schutzdaten und Empfangen der Zustandsüberwachungsdaten entspricht, zu dem Zeitstempel von zumindest einem der empfangenen Schutzdaten und der Zustandsüberwachungsdaten durch den Rechenvorrichtungsprozessor (126), sodass den zum gleichen Zeitpunkt abgetasteten Schutzdaten und Zustandsüberwachungsdaten ein gemeinsamer Zeitstempel zugewiesen wird; und
Zeitsynchronisieren der zumindest einen Schutzrelaisvorrichtung (122) und der zumindest einen M&D-Vorrichtung (124) durch den Rechenvorrichtungsprozessor (126) mit einer gemeinsamen Zeitquelle des Global Positioning System (GPS).

2. Verfahren nach Anspruch 1, weiter umfassend:
Abrufen historischer Daten des Transformators aus einer Datenbank durch den Rechenvorrichtungsprozessor (126);
Vergleichen von zumindest einem Abschnitt der empfangenen Schutzdaten und zumindest einem Abschnitt der empfangenen Zustandsüberwachungsdaten mit den historischen Daten durch den Rechenvorrichtungsprozessor (126);
Bestimmen, durch den Rechenvorrichtungsprozessor (126) und zumindest teilweise basierend auf einem Vergleich von zumindest einem Abschnitt der empfangenen Schutzdaten und zumindest einem Abschnitt der empfangenen Zustandsüberwachungsdaten mit den historischen Daten, einer zumindest teilweisen Übereinstimmung zwischen zumindest einem Abschnitt der empfangenen Schutzdaten und zumindest einem Abschnitt der empfangenen Zustandsüberwachungsdaten und den historischen Daten, wobei zumindest ein Abschnitt der empfangenen Schutzdaten und zumindest ein Abschnitt der empfangenen Zustandsüberwachungsdaten mit einem Abschnitt der historischen Daten übereinstimmen, welcher auf einen früheren Ausfall des Transformators (110) hinweist; und
Identifizieren eines Ausfalls des Transformators (110) durch den Rechenvorrichtungsprozessor (126) und basierend auf Bestimmung einer Übereinstimmung zwischen zumindest einem Abschnitt der empfangenen Schutzdaten und zumindest einem Abschnitt der empfangenen Zustandsüberwachungsdaten und der historischen Daten.

3. Verfahren nach einem der Ansprüche 1 bis 2, weiter umfassend:
Vorhersagen einer nächsten erforderlichen Wartung für den Transformator (110) durch den Rechenvorrichtungsprozessor (126) basierend auf Analysieren der empfangenen Schutzdaten und der empfangenen Zustandsüberwachungsdaten;
Planen der nächsten erforderlichen Wartung für den Transformator (110) in einem Kalender durch den Rechenvorrichtungsprozessor (126);
Erzeugen einer Kalenderanforderung für eine Wartung durch den Rechenvorrichtungsprozessor (126) basierend auf der vorhergesagten nächsten erforderlichen Wartung; und
Übertragen der Kalenderanforderung durch den Rechenvorrichtungsprozessor (126) an ein zweites System (130).

4. Verfahren nach einem der Ansprüche 1 bis 3, weiter umfassend:
Bestimmen, durch den Rechenvorrichtungsprozessor (126) und zumindest teilweise basierend auf Analysieren der empfangenen Schutzdaten und der empfangenen Zustandsüberwachungsdaten, dass der Transformator (110) zumindest einen Satz von Regulierungsstandards nicht mehr erfüllt.

5. Verfahren nach einem der Ansprüche 1 bis 4, weiter umfassend:
Vorhersagen eines Ausfalls des Transformators (110) durch den Rechenvorrichtungsprozessor (126) zumindest teilweise basierend auf Analyse der empfangenen Schutzdaten und der empfangenen Zustandsüberwachungsdaten; und
Stoppen des Betriebs des Transformators durch den Rechenvorrichtungsprozessor (126) als Reaktion auf Vorhersagen eines Ausfalls des Transformators (110)

6. Verfahren nach einem der Ansprüche 1 bis 5, weiter umfassend:
Korrelieren der empfangenen Schutzdaten und der empfangenen Zustandsüberwachungsdaten durch den Rechenvorrichtungsprozessor (126).

7. Verfahren nach einem vorstehenden Anspruch, weiter umfassend:
Berechnen einer Lebensdauer zumindest einer Komponente des Transformators (110) durch den Rechenvorrichtungsprozessor (126) basierend auf Analysieren der empfangenen Schutzdaten und der empfangenen Zustandsüberwachungsdaten.

8. Verfahren nach einem vorstehenden Anspruch, weiter umfassend:
Vorhersagen einer Ursache und eines Typs des vorhergesagten Ausfalls des Transformators (110) durch den Rechenvorrichtungsprozessor (126) zumindest teilweise basierend auf Analyse der empfangenen Schutzdaten und der empfangenen Zustandsüberwachungsdaten.

9. Computerprogramm, umfassend Computerprogrammcodemittel, welche dazu angepasst sind, das Verfahren nach einem der Ansprüche 1 bis 8 durchzuführen, wenn es auf einem Computerprozessor ausgeführt wird.

10. Computerprogramm nach Anspruch 9, realisiert auf einem computerlesbaren Medium.

11. System (100), umfassend:
zumindest eine Schutzrelaisvorrichtung (122);
zumindest eine Vorrichtung zur Überwachung und Diagnose (M&D) (124), welche kommunikativ mit der zumindest einen Schutzrelaisvorrichtung (122) gekoppelt ist; und
zumindest einen Prozessor (126), welcher kommunikativ mit der zumindest einen Schutzrelaisvorrichtung (122) und der zumindest einen M&D-Vorrichtung (124) gekoppelt und dazu konfiguriert, das Computerprogramm nach Anspruch 10 auszuführen, um das Verfahren nach einem der Ansprüche 1 bis 8 durchzuführen.

## Revendications

1. Procédé comprenant :
la réception, par un processeur de dispositif informatique (126), de données de protection d'un transformateur (110) en provenance d'au moins un dispositif de relais de protection (122) ;
la réception, au moyen du processeur de dispositif informatique (126), de données de surveillance de santé du transformateur (110) en provenance d'au moins un dispositif (124) de surveillance et de diagnostic (M & D) ;
l'horodatage, par le processeur de dispositif informatique (126), des données de protection et de surveillance de santé reçues lors de la réception des données de protection et des données de surveillance de santé ;
l'analyse, par le processeur de dispositif informatique (126), des données de protection reçues et des données de surveillance de santé reçues à l'aide d'une référence de temps commune ;
la détermination, par le processeur de dispositif informatique (126), de la survenue d'un événement associé au transformateur (110) sur la base, au moins en partie, de l'analyse des données de protection reçues et des données de surveillance de santé reçues ;
le rappel, par le processeur de dispositif informatique (126), de prédonnées comprenant des données historiques disponibles ou un échantillon de données qui ont été horodatées immédiatement avant l'horodatage de l'événement survenu déterminé et de post-données comprenant un échantillon de données qui ont été horodatées immédiatement, ou de multiples échantillons de données collectés après l'horodatage de l'événement survenu déterminé ;
la génération, au moyen du processeur de dispositif informatique (126), d'une instruction pour modifier le fonctionnement du transformateur (110) à la suite de la détermination de la survenue d'un événement associé au transformateur (110) ;
l'analyse, par le processeur de dispositif informatique (126), des prédonnées et des post-données pour déterminer une cause de l'événement qui est survenu par rapport au transformateur (110) ou pour déterminer une quantité de contrainte subie par le transformateur (110) due à la survenue de l'événement ; et **caractérisé par** la comparaison, par le processeur de dispositif informatique (126), de l'horodatage des données de protection reçues à l'horodatage des données de surveillance de santé reçues ;
la détermination, par le processeur de dispositif informatique (126), d'un temps de retard actuel estimé entre la réception des données de protection et la réception des données de surveillance de santé sur la base de la comparaison de l'horodatage des données de protection reçues à l'horodatage des données de surveillance de santé reçues ; et
l'attribution, par le processeur de dispositif informatique (126), d'un décalage de temps égal au temps de retard actuel estimé entre la réception des données de protection et la réception des données de surveillance de santé à l'horodatage d'au moins une des données de protection reçues et des données de surveillance de santé de telle sorte qu'un horodatage commun soit attribué aux données de protection et données de surveillance de santé échantillonnées au même instant ; et
la synchronisation, par le processeur de dispositif informatique (126), du au moins un dispositif de relais de protection (122) et du au moins un dispositif de M&D (124) avec une source de temps de système mondial de positionnement (GPS) commune.

2. Procédé selon la revendication 1, comprenant en outre :
la récupération, par le processeur de dispositif informatique (126), de données historiques du transformateur à partir d'une base de données ;
la comparaison, par le processeur de dispositif informatique (126), d'au moins une partie des données de protection reçues et d'au moins une partie des données de surveillance de santé reçues aux données historiques ;
la détermination, par le processeur de dispositif informatique (126) et, sur la base, au moins en partie, d'une comparaison d'au moins une partie des données de protection reçues et d'au moins une partie des données de surveillance de santé reçues aux données historiques, d'au moins une correspondance partielle entre au moins une partie des données de protection reçues et au moins une partie des données de surveillance de santé reçues et les données historiques, dans lequel au moins une partie des données de protection reçues et au moins une partie des données de surveillance de santé reçues correspondent à une partie de données historiques indiquant une défaillance antérieure du transformateur (110) ; et
l'identification, par le processeur de dispositif informatique (126) et, sur la base de la détermination d'une correspondance entre au moins une partie des données de protection reçues et au moins une partie des données de surveillance de santé reçues et les données historiques, d'une défaillance du transformateur (110).

3. Procédé selon l'une quelconque des revendications 1 et 2, comprenant en outre :
la prédiction, par le processeur de dispositif informatique (126), d'une prochaine maintenance requise pour le transformateur (110) sur la base de l'analyse des données de protection reçues et des données de surveillance de santé reçues ;
la planification, par le processeur de dispositif informatique (126), de la prochaine maintenance requise pour le transformateur (110) dans un calendrier ;
la génération, par le processeur de dispositif informatique (126), d'une demande de calendrier de maintenance sur la base de la prochaine maintenance requise prévue ; et
la transmission, par le processeur de dispositif informatique (126), de la demande de calendrier à un second système (130).

4. Procédé selon l'une quelconque des revendications 1 à 3, comprenant en outre :
la détermination, par le processeur de dispositif informatique (126) et, sur la base, au moins en partie, de l'analyse des données de protection reçues et des données de surveillance de santé reçues, que le transformateur (110) n'est plus conforme à au moins un ensemble de normes réglementaires.

5. Procédé selon l'une quelconque des revendications 1 à 4, comprenant en outre :
la prédiction d'une défaillance du transformateur (110), par le processeur de dispositif informatique (126), sur la base, au moins en partie, de l'analyse des données de protection reçues et des données de surveillance de santé reçues ; et
l'arrêt, par le processeur de dispositif informatique (126), du fonctionnement du transformateur à la suite de la prédiction d'une défaillance du transformateur (110)

6. Procédé selon l'une quelconque des revendications 1 à 5, comprenant en outre :
la corrélation, par le processeur de dispositif informatique (126), des données de protection reçues et des données de surveillance de santé reçues.

7. Procédé selon une quelconque revendication précédente, comprenant en outre :
le calcul, par le processeur de dispositif informatique (126), d'une durée de vie d'au moins un composant du transformateur (110) sur la base de l'analyse des données de protection reçues et des données de surveillance de santé reçues.

8. Procédé selon une quelconque revendication précédente, comprenant en outre :
la prédiction, par le processeur de dispositif informatique (126), d'une cause et d'un type de défaillance prédite du transformateur (110) sur la base, au moins en partie, de l'analyse des données de protection reçues et des données de surveillance de santé reçues.

9. Programme informatique comprenant des moyens de code de programme d'ordinateur adaptés pour réaliser le procédé selon l'une quelconque des revendications 1 à 8, lorsqu'il est exécuté par un processeur informatique.

10. Programme informatique selon la revendication 9, incorporé sur un support lisible par ordinateur.

11. Système (100) comprenant :
au moins un dispositif de relais de protection (122) ;
au moins un dispositif de surveillance et diagnostic (M&D) (124) couplé en communication à le au moins un dispositif de relais de protection (122) ; et
au moins un processeur (126) couplé en communication à le au moins un dispositif de relais de protection (122) et le au moins un dispositif de M&D (124) et configuré pour exécuter le programme informatique selon la revendication 10 pour réaliser le procédé selon l'une quelconque des revendications 1 à 8.
